# EUROPEAN PATENT SPECIFICATION

(11) **EP 1 412 551 B1**
(45) Date of publication and mention of the grant of the patent: **02.03.2011**
(21) Application number: 02745713.4
(22) Date of filing: 15.07.2002
(51) Int. Cl.: C23C 16/40

(54) **METHOD OF MAKING A PASSIVATED SURFACE**
VERFAHREN ZUR HERSTELLUNG EINER PASSIVIERTEN OBERFLÄCHE
METHODE DE FABRICATION D'UNE SURFACE PASSIVE

(30) Priority: 17.07.2001 US 306014 P; 29.05.2002 US 157466
(43) Date of publication of application: 28.04.2004
(73) Proprietor: L'AIR LIQUIDE, Société Anonyme pour l'Etude et l'Exploitation des Procédés Georges Claude, 75007 Paris (FR)
(72) Inventor: JACKSIER, Tracey, Lile, IL 60532 (US); BENESCH, Robert, Clarendon Hills, IL 60514 (US)
(74) Representative: Ducreux, Marie
(86) International application number: PCT/IB2002/002770
(87) International publication number: WO 2003/008664

(56) References cited:
- WO-A-99/43445
- US-A- 4 385 086
- DATABASE WPI Section Ch, Week 197841 Derwent Publications Ltd., London, GB; Class A32, AN 1978-73465A XP002230629 & JP 53 100979 A (NICHIDEN VARIAN KK), 2 September 1978 (1978-09-02)

## Description

### Background of the Invention

### 1. Field of the Invention

The invention is generally related to the field of gases and packaging and using same. More specifically, the invention relates to increased stability, low concentration reactive gases, products including same, and methods of making same.

### 2. Related Art

Moisture is known to react with so-called "acid gases", such as hydrogen sulfide, carbonylsulfide, carbondisulfide and mercaptans (mercaptans are also referred to as thiols) to form a complex compound. (The term "acid gas" is used herein to denote either gas phase, liquid phase, or mixture of gas and liquid phases, unless the phase is specifically mentioned.)

One problem presents itself: if one is interested in producing acid gas standard compositions, in other words acid gases having a known concentration of one of these gases in a matrix or carrier fluid, then one must consider how to reduce or remove the moisture. Gas standards may have to have, and preferably do have, a long shelf life, since the standard acid gas may not be required immediately after production. A source of acid gas and/or matrix gas may contain a considerable amount of moisture. Therefore, the reduction or removal of moisture from the acid gas is of primary importance if the stability of the acid gas in the standard gas is to be maintained.

U.S. Pat. Nos. 5,255,445 and 5,480,677 describe processes for drying and passivating a metal surface to enhance the stability of gas mixtures containing one or more gaseous hydrides in low concentrations in contact therewith. The process comprises purging gas in contact with the metal surface with inert gas to remove the purged gas, exposing the metal surface to an amount of a gaseous passivating or drying agent comprising an effective amount of a gaseous hydride of silicon, germanium, tin or lead and for a time sufficient to passivate the metal surface, and purging the gaseous passivating agent using inert gas. Optionally, an oxidizing agent is applied after the third step to stabilize the adsorbed stabilizing agent. The patent also mentions prior known processes, such as saturation passivation, where the container is subjected to several cycles of evacuating and filling with a much higher concentration of the same gaseous hydride, prior to being filled with the low concentration hydride mixture of interest. The two patents do not mention or describe processes to passivate containers adapted to store sulfur-containing gases, nor do they mention passivation techniques in which a first passivating agent is applied to the surface, followed by contacting with a higher concentration of the gas to be stored.

US 6 752 852 B1 describes the use of certain acid gas resistant molecular sieves to reduce or remove moisture from fluid compositions comprising a sulfur-containing compound. There is no disclosure or suggestion, however, for the passivation of containers adapted to contain the moisture-reduced compositions. Such containers may have moisture adhered to the internal surfaces, which can and does react with acid gases, reducing their stability and shelf-life.

Given the problem of moisture reacting with acid gases and reactive gases in general, it would be advantageous if passivation methods could be provided which increase the shelf-life during the storage of these compounds.

### Summary of the Invention

In accordance with the present invention, methods of passivating internal surfaces of containers that have been cleaned are employed to increase the shelf-life of gas compositions, especially low concentration gas products. As used herein the term "shelf-life" means that time during which the initial concentration of a gas stored in a container is substantially maintained at the intended or desired concentration. In this context, the phrase "substantially maintained" means that for concentrations of about 1000 parts per billion (ppb), the concentration does not vary by more than +/- 10 percent; for concentrations of about 500 ppb, the concentration does not vary by more than +/- 15 percent; for concentrations of about 100 ppb, the concentration does not vary by more than +/- 20 percent. "Low concentration" means gases having a concentration in another gas, such as inert gas, of 1000 ppb or less.

Gases which benefit for the passivation techniques of the present invention include nitrous oxide, nitric oxide, hydrogen chloride, chlorine, boron trichloride, and any acid gases except those that would react with a silicon-containing compound.

As used herein the term "acid gas" means sulfur-containing compounds, including carbon disulfide, carbonylsulfide, and compounds within formula (I):

Y-S-X (I)

wherein S is sulfur,
X and Y are the same or different and are independently selected from the group consisting of hydrogen, alkyl, aryl, oxygen, hydoxyl, amine, aminosilane, oxygen, and alcohol.
Examples of preferred sulfur-containing compounds within formula (I) include hydrogen sulfide, methylthiol, ethylthiol, n-propylthiol, i-propylthiol, benzylthiol, and the like.

A first aspect of the invention relates to a manufactured product comprising:
a) a container having an internal space and a passivated internal metal surface;
b) a composition comprising a reactive gas contained within the internal space and in contact with the passivated internal metal surface, the reactive gas having an intended concentration that is substantially maintained; and
c) the passivated internal metal surface comprising:
   1) the reaction product of a silicon-containing material and an oxygen-containing material (preferably selected from the group consisting of moisture, molecular oxygen, metal oxides, and mixtures thereof), and
   2) an effective amount of the reactive gas, the effective amount being many times the intended concentration of reactive gas that is to be substantially maintained.

Preferred manufactured products of the invention are those wherein the reactive gas is selected from the group consisting of chlorine and an acid as selected from the group consisting of carbondisulfide, carbonylsulfide, and compounds within formula (I). Other preferred manufactured products include products wherein the passivated internal surface is a passivated metal. Preferably the metal is selected from the group consisting of aluminum, aluminum alloys, steel, iron and combinations thereof. Yet other preferred manufactured products of the invention are those wherein the silicon-containing material is selected from the group consisting of compounds within the general formula (II):

SiR¹R²R³R⁴ (II)

wherein R1, R2, R3, and R4 are the same or different and are independently selected from the group consisting of hydrogen, halogen, amine, alkyl, aryl, halogenated alkyl, and halogenated aryl; and manufactured products wherein the compound is silane or a methyl-containing silane, more preferably wherein the methyl-containing silane is selected from the group consisting of methylsilane, dimethylsilane, trimethylsilane and tetramethylsilane.

Preferred manufactured products of the invention are those wherein the composition comprises a reactive gas having a concentration of about 1000 ppb and that does not vary by more than +/- 10 percent; products wherein the composition comprises a reactive gas having a concentration of about 500 ppb and that does not vary by more than +/- 15 percent; products wherein the composition comprises a reactive gas having a concentration of about 100 ppb and that does not vary by more than +/- 20 percent;. Products wherein the composition comprises higher or lower concentration of reactive gas, and correspondingly larger or smaller variation in concentration, are considered within the invention.

Preferred manufactured products of the invention comprise only a single reactive gas with an inert gas like nitrogen, argon, helium, and the like. The composition may comprise a mixture of two or more reactive gases. Also, the balance of the fluid composition is, in some preferred embodiments, a hydrocarbon, such as ethylene, propylene, and the like.

A second aspect of the invention is a method of making a manufactured product of the invention, the method comprising the steps of:
i) exposing an internal metal surface of a container to a first fluid composition comprising a silicon-containing compound for a time sufficient to allow at least some of the silicon-containing compound to react with oxygen-containing compounds (preferably selected from the group consisting of moisture, molecular oxygen, metal oxides, and mixtures thereof) present to form a silicon-treated surface on at least some of the internal metal surface, the silicon-containing compound selected from the group consisting of compounds within the general formula (II):

   SiR¹R²R³R⁴ (II)

   wherein R1, R2, R3, and R4 are the same or different and are independently selected from the group consisting of hydrogen, halogen, alkyl, aryl, amine, halogenated alkyl, and halogenated aryl;
ii) evacuating the container for a time sufficient to remove substantially all of the silicon-containing compound(s) that has not reacted with the oxygen-containing compound to form the silicon-treated surface;
iii) exposing the silicon-treated surface to a second fluid composition, the second fluid composition comprising a reactive gas having a concentration that is greater than an intended reactive gas concentration of the manufactured product;
iv) evacuating the container for a time sufficient to remove just enough of the second fluid composition to enable maintenance of an increased shelf life, low concentration reactive gas at the intended concentration in the container; and
v) filling the container with a third fluid composition having the intended reactive gas concentration for the manufactured product.

Preferred methods in this aspect of the invention are those wherein the silicon-containing compound is silane or a methyl-containing organosilane; particularly those wherein the methyl-containing organosilane is selected from the group consisting of silane, methylsilane, dimethylsilane, trimethylsilane and tetramethylsilane. Also preferred are methods wherein the second fluid composition has a concentration of reactive gas at least 10 times the intended reactive gas concentration of the manufactured product; methods wherein steps i) and ii) are repeated prior to step iii); methods wherein the metal surface is cleaned prior to step i); methods wherein the concentration of the silicon-containing compound used in step i) ranges from about 100 ppm to 100 percent; methods wherein during step i) the silicon-containing compound is heated to a temperature of not more than 74°C, and methods wherein during step iii) the second composition is heated to a temperature of not more than 74°C. Other preferred methods are those wherein the container is a gas cylinder having an attached cylinder valve, and the cylinder valve is removed prior to step i). After all the steps are completed, preferably at very high temperatures for steps i) and iii), the cylinder valve is reattached, and the process steps i) - v) are repeated, but steps i) and iii) take place at not more than 74°C.

A third aspect of the invention is a method of passivating a metal surface, the method comprising the steps of:
i) exposing the metal surface to a first composition comprising a silicon-containing compound for a time sufficient to allow at least some of the silicon-containing compound to react with oxygen-containing compounds present to form a silicon-treated surface on at least some of the metal surface, the silicon-containing compound selected from the group consisting of compounds within the general formula (II):

   SiR¹R²R³R⁴ (II)

   wherein R1, R2, R3, and R4 are the same or different and are independently selected from the group consisting of hydrogen, halogen, amine, alkyl, aryl, halogenated alkyl, and halogenated aryl;
ii) evacuating the surface for a time sufficient to remove substantially all silicon-containing compound that has not reacted with the oxygen-containing compound to form the silicon-treated surface;
iii) exposing the silicon-treated surface to a second fluid composition, the second fluid composition comprising a reactive gas having a concentration that is greater than an intended reactive gas concentration to be in contact with the silicon-treated surface;
iv) evacuating the surface for a time sufficient to remove just enough of the second fluid composition to enable maintenance of a low concentration of reactive gas at an intended concentration; and
v) exposing the metal treated surface to a third fluid composition having concentration of reactive gas at the intended reactive gas concentration.

Preferably, the metal surface is part of a pipe, piping manifold, tubing, tubing manifold, ton unit, tube trailer, tank trailer, cylinder, flow regulator, pressure regulator, valve, cylinder valve, or other pressure-reducing device. The metal surface is preferably cleaned prior to step i) as disclosed further herein.

Further aspects and advantages of the invention will become apparent by reviewing the description of preferred embodiments that follow.

### Brief Description of the Drawing

FIG. 1 is a logic diagram illustrating the methods of the invention

FIG. 2 illustrates that a prior art process of "vacuum baking" an aluminum cylinder at 65°C to vacuum of 1 micrometer Hg for 3 days was not sufficient to provide stability of a 150 ppb H₂S balance nitrogen mixture for a cylinder which was previously exposed to moisture;

FIG. 3 illustrates that a prior art process of passivation of a cylinder and valve after vacuum baking with a high concentration of the gas mixture to be prepared, which had also been used to extend shelf life of a high purity mixture, did not prove successful; and

FIGs. 4 and 5 illustrate stability of gas products made in accordance with the invention.

### Description of Preferred Embodiments

While the following discussion focuses on a container which has a metal internal surface, the description is not limited thereto, and could apply to a piping or tubing system, a manifold, a gas cylinder having a cylinder valve, ton unit, and the like.

Silicon-containing compounds within the general formula (II) are known to react with oxygen-containing compounds, such as H₂O N₂O, CO₂ and the like, to produce SiO₂, especially when the silicon-containing compounds are in the gaseous or vapor state. This fact is taken advantage of in the practice of the various aspects of the invention. The reaction product of a silicon-containing compound and an oxygen-containing compound such as water forms an amorphous or crystalline glassy material on the surfaces on which it is deposited. The amorphous or crystalline glassy material may include aluminum silicide, if the container or surface being treated comprises aluminum. Although the deposited material is referred top herein as a "coating", it shall be readily understood that in fact the material may deposit non-uniformly, or not at all on certain areas of the surface being treated. This coating then serves the function of deactivating a surface for the adsorption of molecules of the gas that is ultimately to be contained in the container or piping system at low concentration. In other words, the coating serves to decrease the number of reactive sites on the metal surface being treated. For simplicity, silicon-containing compounds within formula (II) shall be referred to as organosilanes, although their formal name under IUPAC convention may differ.

The reaction of an organosilane within general formula (II) with oxygen-containing materials such as water proceeds without catalyst at room temperature (25°C); however, it is preferred to carry out the reaction at moderately elevated temperatures, such as temperature ranging from 25°C up to 100°C, in order to produce the coatings in reasonable time. The pressure of the reaction of an organosilane with water vapor will generally also proceed at atmospheric pressure, however, the pressure in the container, or near the surface being treated, may either be in vacuum or above atmospheric pressure. This will of course depend on the rates of reaction of the organosilane with the oxygen-containing compound, the desired coating deposition rate, and desired thickness of the coating. It is of course within the invention to make layered coatings of two or more organosilane/oxygen-containing compound reaction products. It is also considered within the invention to employ two or more organosilanes simultaneously to make a "mixed" coating. Indeed, it is possible that the organosilane may be employed in conjunction with a non-organosilane to form either layered or mixed coatings.

Silane and organosilanes are toxic materials, and, depending on the organosilane, pyrophoric. Special care in handling these materials is warranted, preferably well-ventilated hoods. Electronic grade silane (SiH₄) is available commercially in cylinders from Air Liquide America Corporation, Houston, Texas. Trimethylsilane is available commercially from Dow Corning Corporation.

Preferred silicon-containing compounds include silane, and methyl-containing organosilanes; particularly those wherein the methyl-containing organosilane is selected from the group consisting of methylsilane, dimethylsilane, trimethylsilane and tetramethylsilane. Preferred organosilane compounds include methylsilane compounds having the structure SiHₙ(CH₃)₄₋ₙ, where n=1 to 3, i.e. methylsilane, dimethylsilane, or trimethylsilane or the structure Si₂Hₘ(CH3)₆₋ₘ, where m=1 to 5. The most preferred organosilane compound is methylsilane, CH₃SiH₃. The organosilane compounds are hydrolyzed by reaction with water, oxygen or water-containing gases such as humid air and/or other oxygen-containing gases, such that the carbon content of the deposited film is from 1 to 50% by atomic weight, preferably about 20%.

It is conceivable to employ adjuvants during the reaction of an organosilane with water. In the practice of the invention, "adjuvant" includes physical and chemical adjuvants, and combinations thereof. Suitable physical adjuvants include electrostatic discharge, plasma discharge, laser excitation, and the like, under temperatures and pressures suitable for each of these processes. For example, plasmas are preferably best employed in moderate vacuum. A chemical adjuvant might include an oxidant gas such as oxygen, ozone, chlorine dioxide, combinations thereof and the like. When a combination of physical and chemical adjuvants is employed, for example ozone and plasma discharge, the reaction product may be described as similar to the films produced b the process described in U.S. Pat. No. 6,054,379, which is incorporated herein by reference for its teaching of the production of such films.

The container or surface to be treated may be selected from the group consisting of iron, stainless steel (for example 301, 316, 401), aluminum, aluminum alloy, steel alloys and the like. The internal surface of the container, or the surface to be treated, may be subject to abrasion prior to reaction of the organosilane with water vapor in order to improve adhesion of the reaction product to the metal. Residues may be removed by a variety of mechanical means such as scrubbing, grinding, and peening. Scrubbing may be performed with non-woven abrasives. The use of lofty, fibrous, nonwoven abrasive products for scouring surfaces such as the soiled surfaces of pots and pans is well known. These products are typically lofty, nonwoven, open mats formed of staple fibers which are bonded together at points where they intersect and contact each other. The staple fibers of low-density abrasive products of this type can be, and typically are, bonded together at points of contact with a binder that may or may not contain abrasive particles. The staple fibers are typically crimped, have a length of about 3.8 cm, a diameter ranging from about 25 to about 250 micrometers, and are formed into lofty open webs by equipment such as "Rando-Webber" and "Rando-Feeder" equipment (marketed by the Curlator Corporation, of Rochester, N.Y. and described in U.S. Pat. Nos. 2,451,915; 2,700,188; 2,703,441 and 2,744,294). One very successful commercial embodiment of such an abrasive product is that sold under the trade designation "Scotch-Brite" by Minnesota Mining and Manufacturing Company of St. Paul, Minn. ("3M"). Low-density abrasive products of this type can be prepared by the method disclosed by Hoover et al. in U.S. Pat. No. 2,958,593, incorporated herein by reference.

Low-density, lofty abrasive products may also be formed of webs or mats of continuous filaments. For example, in U.S. Pat. No. 4,227,350, Fitzer, incorporated herein by reference, discloses a low-density abrasive product comprising a uniform cross-section, generally flat-surfaced, open, porous, lofty web of autogenously bonded, continuous, undulated, interengaged filaments. The web of Fitzer is formed by downwardly extruding a plurality of thermoplastic organic (e.g. polyamide, polyester) filaments from a spinneret into a quench bath. As the filaments enter the quench bath, they begin to coil and undulate, thereby setting up a degree of resistance to the flow of the molten filaments, causing the molten filaments to oscillate just above the bath surface. The spacing of the extrusion openings from which the filaments are formed is such that, as the molten filaments coil and undulate at the bath surface, adjacent filaments touch one another. The coiling and undulating filaments are still sufficiently tacky as this occurs, and, where the filaments touch, most adhere to one another to cause autogenous bonding to produce a lofty, open, porous, handlable filament web. The web, so formed, is then impregnated with a tough binder resin which adherently bonds the filaments of the web together and also bonds a multitude of abrasive granules, uniformly dispersed throughout the web, to the surface of the filaments. Fibrous polishing and/or abrading materials can be prepared from continuous or substantially continuous synthetic filaments by the method disclosed by Zimmer et al., in U.S. Pat. No. 3,260,582, incorporated herein by reference. In this method crimped or curled continuous filaments are straightened out under tension into a substantially parallel relationship with one another, uniformly coated while under tension with an adhesive which may or may not contain abrasive particles, interlocked with one another by release of such tension and then set in a permanently interlocked and lofty, open, 3-dimensional state by curing or setting up the adhesive. Low-density, lofty, open, porous, nonwoven scouring articles have been more easily and economically manufactured from continuous filaments by the method disclosed by Heyer et al., in U.S. Pat. Nos. 4,991,362, and 5,025,596, both incorporated herein by reference. The scouring pads described in these patents comprise a multiplicity of crimped or undulated, continuous, thermoplastic organic filaments that are bonded together (e.g., by fusion or an adhesive) at opposite ends. The pad is made by arranging a multiplicity of continuous, crimped or undulated, thermoplastic organic filaments in an open lofty array, with one point of each filament in the array corresponding to a first filament bonding site and a second point of each filament, distant from the first point, corresponding to a second filament bonding site. A pad is formed in the filament array by bonding substantially all of the thermoplastic organic filaments together at the first and second bonding sites. When a pad having greater abrasiveness is desired, abrasive particles may be adherently bonded to the filaments of the pad, preferably before the individual pad is cut from the filament array. These pads have also enjoyed commercial success and are economical to make. U.S Pat. No. 5,363,604, incorporated by reference, describes nonwoven scouring articles comprising a low-density, lofty, open, porous, nonwoven web, the web comprising a multiplicity of crimped or undulated, continuous, preformed thermoplastic organic filaments, at least partially coated with an organic thermoset binder which binds the filaments at least at a portion of points where they contact. The continuous thermoplastic organic filaments, preferably in the form of tow, are entangled together at a multiplicity of points along their length to provide a cross-direction tensile strength the web of at least about 0.02 kg/cm, more preferably at least about 0.03 kg/cm, before coating the web with a thermosetting binder precursor solution. The continuous filaments are "entangled", preferably by needlepunching from a plurality of directions perpendicular to the machine direction. Other background references include U.S. Pat. Nos. 3,688,453; 4,622,253; 4,669,163; 4,902,561; 4,927,432; 4,931,358; and 4,935,295; World Patent Application No. WO 92/01536, published Feb. 6, 1992; European Patent Application number 0 492 868 A1, published Jul. 1, 1992, the disclosures of which are incorporated herein by reference.

Other means of removing residues from metal surfaces include grinding, such as by using so-called bonded abrasives. Bonded abrasives typically consist of a shaped mass of abrasive grains held together by a binder. The shaped mass can be in any number of conventional forms such as wheels, points, discs, and cylinders, but is preferably in the form of a grinding wheel. A preferred bonded abrasive product useful in the present invention comprises between about 50 to about 90 weight percent abrasive grains dispersed and adhered within a binder. Bonded abrasives products are preferably manufactured by a molding process, and are made with varying degrees of porosity to control the breakdown. Bonded abrasives which may be used for this purpose are such as those described in U.S. Pat. Nos. 5,250,085; 5,269,821; and 5,273,558, all incorporated herein by reference. Abrasive products comprising a solid or foamed organic polymeric matrix having abrasive granules dispersed throughout and bonded therein are well known and widely used. Typically, the polymeric matrix is composed of either a hard, thermoset resin, such as a catalyzed phenol-formaldehyde, or resilient elastomer, such as a polyurethane or a vulcanized rubber.

Bonded abrasives are to be distinguished from coated abrasives in their construction and mode of operation. Bonded abrasives (e.g., grinding wheels) are three-dimensional structures of binder and abrasive grains which rely upon the continual breakdown and removal of the abrasive grains on the cutting surface to continually present sharp cutting points to the material being ground. Coated abrasives, on the other hand, typically have only a single layer of abrasive grains. See, for example, U.S. Pat. No. 5,011,512, incorporated herein by reference.

When elastomeric binder matrices are used in bonded abrasives they generally produce an abrasive article having some degree of flexibility and resiliency. These abrasive articles typically provide a smoother abrasive action and a finer surface finish than that provided by a bonded abrasive article made with hard, thermoset resin. As a result of this, elastomeric bonded abrasive articles have found a wide range of industrial applications, such as deburring, finishing, and sanding in the metal and wood-working industries. However, often these elastomeric bonded abrasive articles have shown premature loss of abrasive particles and, in some cases, undesirable smearing or transfer of portions of the elastomeric binder to the surface of the workpiece.

Conventional flexible bonded abrasive articles typically employ an elastomeric polyurethane as the binder matrix. The polyurethane binder matrix may be a foam, as disclosed in U.S. Pat. Nos. 4,613,345, 4,459,779, 2,972,527, 3,850,589; UK Patent Specification No. 1,245,373 (published Sep. 8,1971); or the polyurethane binder may be a solid, as disclosed in U.S. Pat. Nos. 3,982,359, 4,049,396, 4,221,572, and 4,933,373, all incorporated herein by reference.

For very large containers, such as ton units, bullets, and spheres, peening may be used with success to remove residues, scales and other deposits on internal surfaces of these containers. U.S. Pat. Nos. 3,638,464 and 3,834,200 (incorporated herein by reference) disclose a high-intensity peening flap construction which includes an elongate strap of a flexible, tear-resistant material, and at least one metal peening particle support base fastened to the elongate strap. A plurality of refractory-hard, impact fracture-resistant peening particles are metallurgically joined to an exposed face of the support base. In use, one or more of the flaps are mounted on a hub, and the hub is rotated while the flaps are forced against the workpiece to be peened. The peening particles on each support base strike the workpiece in turn, thereby causing the peening particles to perform their normal peening function, but preventing the normal uncontrolled scattering which occurs in conventional shot peening. Improvements to these articles are described in U.S Pat. Nos. 5,179,852 and 5,203,189, incorporated herein by reference where necessary to understand their use in removing residues.

Once the metal container inner surface, or metal surface to be treated is cleaned, and the reaction of organosilane with oxygen-containing compounds completed, either with or with out adjuvants, to form a coating, the processes of the invention comprise evacuating the container for a time and vacuum sufficient to remove substantially all organosilane that has not reacted with oxygen-containing compounds. This first evacuation step preferably includes evacuation down to a vacuum of about 1__torr, more preferably down to 0.01 torr. The temperature during this evacuation process is not critical, but higher temperatures may tend to increase the removal rate of organosilane. This will be balanced by safety issues, in that higher temperatures may be more hazardous. Therefore, room temperature (about 25°C), or slightly lower or slightly higher than room temperature is preferred.

Subsequent to this first evacuation step, the next step is exposing the coating to a gas composition, the gas composition having a concentration of reactive gas that is greater than an intended reactive gas concentration of a manufactured product. The reactive gas is caused to contact the coating and deactivate the surface even further. The reactive gas preferably has a concentration of at least 10 times the concentration of the reactive gas that is to be ultimately stored in the container or exposed to the surface, and more preferably has a concentration 500 times greater than the ultimate concentration, even more preferably 50,000 times the concentration of the reactive gas to be stored in the container or exposed to the surface.

The degree of adsorption of the reactive gas onto the coating depends in a complicated way on the composition and physical properties of the coating, the temperature and pressure employed during this step, as well as on the chemical and physical properties of the particular reactive gas that is being adsorbed thereon. These parameters are in turn dictated by the final concentration of reactive gas that is to be stored in the container. A discussion of adsorption of gaseous species onto surfaces that is helpful in this respect is included in Daniels, F. et al., "Experimental Physical Chemistry", Seventh Edition, McGraw-Hill, pages 369-374 (1970). While the inventors are not certain, it is believed that the attraction of the reactive gas to the coating is physical in nature, involving an interaction of dipoles or induced dipoles, but may be chemical in nature involving chemical bonds, as when oxygen is adsorbed on charcoal. A combination of physical and chemical forces may be at work as well. Thus, the surface area of a coating produced by the practice of the present invention may be determined by the B.E.T. method, and preferably is at least about 1 m²/gram, more preferably at least 10 m²/gram. If the coating is somewhat porous, the pore volume may be determined by nitrogen adsorption isotherm methods, and is preferably at least 0.1 ml/gram. The B.E.T. method is described in detail in Brunauer, S. Emmet, P. H., and Teller, E., J.Am.Chem.Soc., 60, 309-16 (1938). The nitrogen adsorption isotherm method is described in detail in Barrett, E. P., Joyner, L. G. and Helenda, P. P., J.Am.Chem.Soc., 73, 373-80 (1951), incorporated by reference herein. In general, if the concentration of reactive gas to be stored in the container is 100 ppb, then for the same reactive gas, same temperature and pressure, and same coating, the concentration of reactive gas used in this step will be higher than if the ultimate concentration of reactive gas is to be only 50 ppb, assuming adsorption is the governing pathway. An increase in temperature will tend to require an increase in concentration of reactive gas, an increase in pressure, or both, to achieve the same degree of adsorption. In contrast, a decrease in temperature will tend to require a decreased concentration of reactive gas, a decrease in pressure, or both to achieve the same level of adsorption.

After the surface has been further deactivated by exposure to the reactive gas at high concentration, a second evacuation step is carried out to remove excess reactive gas. In this step, evacuation of the container is carried out for a time sufficient to remove substantially all of non-adsorbed reactive gas, leaving reactive gas adsorbed on the coating. The container is then filled with a gas composition comprising the intended low concentration of reactive gas.

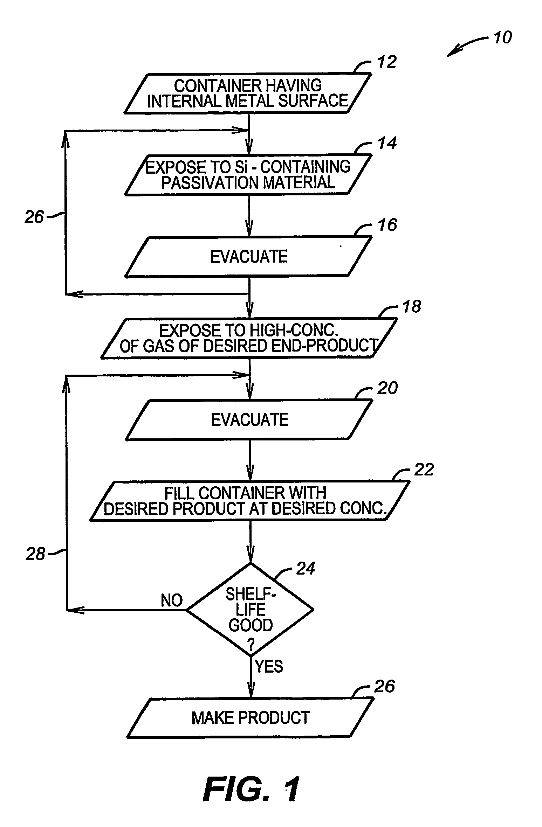

Referring now to FIG. 1, there is illustrated schematically a logic diagram for carrying out processes of the invention. A container having a metal internal surface is selected at 12. The metal surface is exposed to a silicon-containing passivation material, 14, for a time and at a temperature and pressure sufficient to react most of the silicon-containing material with oxygen-containing compounds present on the metal surface. The container is then evacuated for a time sufficient to remove the bulk of the non-reacted silicon-containing material, at 16. Next, the metal surface is exposed to high concentration of reactive gas or liquid of the desired end product to be contained in the container, at 18. The container is again evacuated at 20 for a time sufficient to remove substantially all of the non-adsorbed reactive gas, then the container is filled with the composition having the desired material at the desired concentration, at 22. At this point, the container is allowed to equilibrate and the concentration of the gas in the container is tested at various times to determine the concentration of reactive gas in the container. If the shelf life is acceptable at 24, the product is made in accordance with the procedure followed, at 26. If the concentration of the gas increases or decreases beyond the accepted tolerances, then the process of steps 20, 22, and 24 are repeated. Optionally, steps 14 and 16 may be repeated, as indicated at 26.

### 1. Examples

In the following examples, hydrogen sulfide concentrations were measured using a chemiluminescence detector.

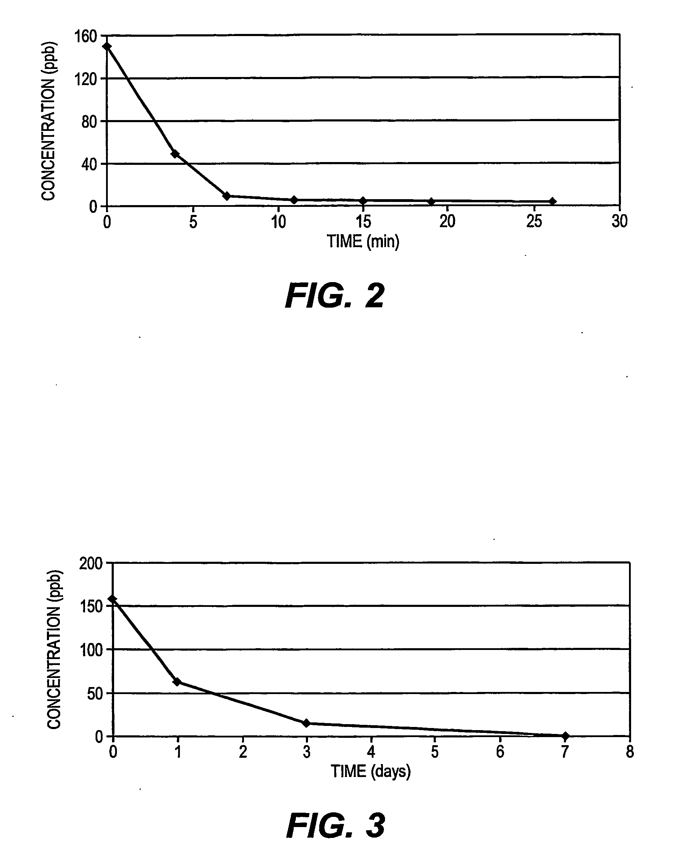

Comparative Example 1. Vacuum baking has long been employed to reduce moisture in cylinders to prevent and/or decrease corrosion due to acid as reactions with moisture and the cylinder wall (and cylinder valve). However, as illustrated in
FIG. 2, vacuum baking an aluminum cylinder at 65°C to vacuum of 1 micrometer of Hg for 3 days was not sufficient to provide stability of a 150 ppb H₂S balance nitrogen mixture for a cylinder which was previously exposed to moisture.

Comparative Example 2. Passivation of the cylinder and valve after vacuum baking with a high concentration of the gas mixture to be prepared has also been used to extend shelf life of high purity mixtures. However, this has not proved successful. After an initial vacuum baking as in Comparative Example 1, the cylinder was subsequently filled with 5000 ppm of H₂S balance nitrogen and heated at 80°C for 3 days. After 3 days the contents were emptied and a vacuum pulled on the cylinder in order to remove all residual H₂S. The cylinder was subsequently filled with 150 ppb H₂S balance nitrogen. As illustrated in FIG. 3, although the stability of the mixture was enhanced, a fast decay was still observed.

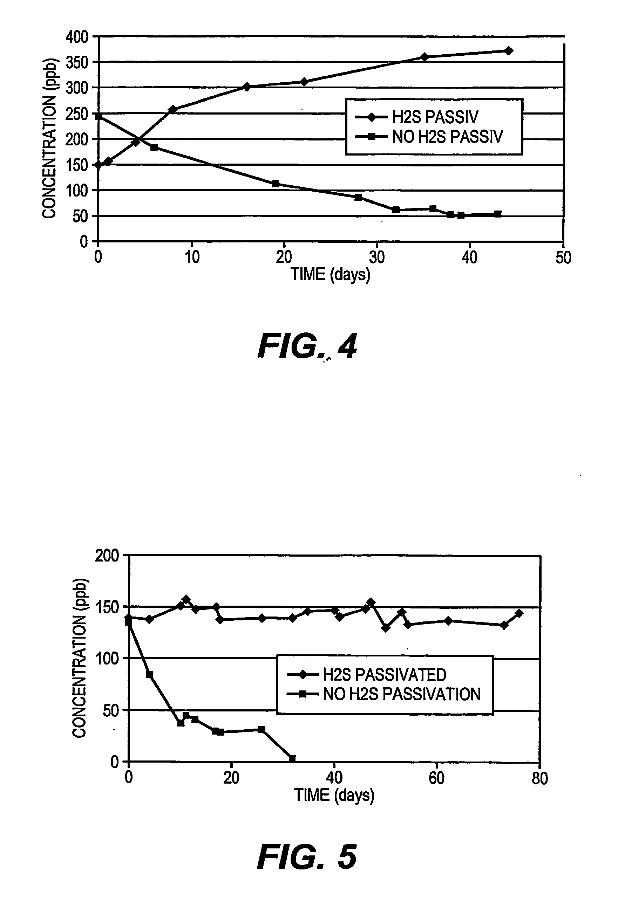

Example 1. Silane, a silicon-containing material having the formula SiH₄, is known to react with moisture and other oxygen-containing compounds and hydrogen. It has also been reported that SiO₂ can bind to aluminum, and we have data indicating formation of weak Si-Al bonds when treating an aluminum alloy cylinder known under the trade designation "Calgaz 3003". In this example, a 1 percent silane balance nitrogen mixture was introduced into an aluminum cylinder (note: this was not a cylinder known under the trade designation "Calgaz 3003") and left in the cylinder overnight. Subsequently the balance was vacuumed out and the cylinder was filled with a 250 ppb H₂S balance nitrogen mixture. As illustrated in FIG. 4, the signal decay for the curve labeled "No H₂S Passiv" was slower than observed previously, indicating that the reaction of moisture with the H₂S was not solely responsible for the loss of stability of the H₂S. The cylinder was subsequently evacuated and passivated with a 5000 ppm mixture of H₂S at 62°C. The cylinder was evacuated and filled with 150 ppb H₂S. The signal was observed to increase with time, indicating that substantially all of the passivation mixture had not been removed prior to filling.

Example 2. Applying the same silane treatment followed by H₂S passivation as in Example 1, but using a longer vacuum time period to remove extraneous silane, it was possible to achieve a stable H₂S mixture, as illustrate in FIG. 5 by the curve labelled "H2S Passivated."

Although the description herein is intended to be representative of the invention, it is not intended to limit the scope of the appended claims.

## Claims

1. A manufactured product comprising a gas having an extended shelf-life, the product comprising:
a) a container having an internal space and a clean and passivated internal metal surface;
b) a composition comprising a reactive gas contained within the internal space and in contact with the clean passivated internal metal surface, the reactive gas having a concentration that is substantially maintained; and
c) the clean and passivated internal metal surface comprising :
1) the reaction product of a silicon-containing material and an oxygen-containing material, and
2) an effective amount of the reactive gas, the amount resulting from a previous exposure of said reaction product to a high concentration of the reactive gas before evacuation of the high concentration reactive gas from the internal space and prior to filling the internal space with the composition, the high concentration being greater than the concentration of reactive gas being substantially maintained.

2. The product of claim 1 wherein said reactive gas is selected from the group consisting of nitrous oxide, nitric oxide, hydrogen chloride, chlorine, boron trichloride, and acid gases that will not react with a silicon-containing material.

3. The product of claim 2 wherein said acid gas is selected from the group consisting of carbondisulfide, carbonylsulfide, and compounds within formula (I) :
Y-S-X (I)
wherein S is sulfur, and
X and Y are the same or different and are independently selected from the group consisting of hydrogen, alkyl, aryl, oxygen, hydroxyl, amino. and aminosilane.

4. The product of claim 1 wherein said passivated internal surface is a passivated metal.

5. The product of claim 4 wherein said metal is selected from the group consisting of aluminum, aluminum alloys, steel, iron and combinations thereof.

6. The product of claim 1 wherein said silicon-containing material is selected from the group consisting of compounds within the general formula:
SiR1 R2R3R4
wherein R1, R2, R3, and R4 are independently selected from the group consisting of hydrogen, halogen, alkyl, aryl, amine, halogenated alkyl, and halogenated aryl.

7. The product of claim 6 wherein said compound is a methyl-containing silane.

8. The product of claim 7 wherein said methyl-containing silane is selected from the group consisting of methylsilane, dimethylsilane, trimethylsilane and tetramethylsilane.

9. The product of claim 1 wherein the composition has a reactive gas concentration of about 1000 ppb and which does not vary by more than +/-10 percent.

10. The product of claim 1 wherein the composition has a reactive gas concentration of about 500 ppb and does not vary by more than +/-15 percent.

11. The product of claim 1 wherein the composition has a reactive gas concentration of about 100 ppb and does not vary by more than +/-20 percent.

12. The product of claim 1 wherein the composition comprises a single reactive gas mixed with a gas selected from the group consisting of an inert gas, a hydrocarbon gas, and mixtures thereof.

13. A method, of making the manufactured product of claim 1 from a clean container, the method comprising the steps of :
i) exposing an internal metal surface of a container to a first fluid composition comprising a silicon-containing compound for a time sufficient to allow at least some of the silicon-containing compound to react with an oxygen-containing compound present to form a silicon-treated surface on at least some of the internal metal surface, the silicon-containing compound being selected from the group consisting of compounds within the general formula:
SiR1 R2R3R4
wherein R1, R2, R3, and R4 are the same or different and are independently selected from the group consisting of hydrogen, halogen, alkyl, aryl, amine, halogenated alkyl, and halogenated aryl;
ii) evacuating the container for a time sufficient to remove substantially all silicon-containing compound that has not reacted with the oxygen-containing compound to form the silicon-treated surface;
iii) exposing the silicon-treated surface to a second fluid composition, the second fluid composition comprising a reactive gas having a concentration that is greater than an intended reactive gas concentration of the manufactured product;
iv) evacuating the container for a time sufficient to remove substantially all of the second fluid composition, thus forming said passivated internal metal surface in the container; and
v) filling the container with a third fluid composition having the intended reactive gas concentration for the manufactured product.

14. The method of claim 13 wherein the silicon-containing compound is selected from the group consisting of silane and a methyl-containing silane.

15. The method of claim 14 wherein said methyl-containing silane is selected from the group consisting of methylsilane, dimethylsilane, trimethylsilane and tetramethylsilane.

16. The method of claim 13 wherein the second fluid composition has a concentration of reactive gas at least 10 times the intended reactive gas concentration.

17. The method of claim 13 wherein steps i) and ii) are repeated prior to step iii).

18. The method of claim 13 wherein the composition of the silicon-containing gas used in step iii) ranges from about 100 ppm to 100 percent.

19. The method of claim 13 wherein during step i) the first fluid composition is heated to a temperature of not more than 74 °C.

20. The method of claim 13 wherein during step iii) the second fluid composition is heated to a temperature of not more than 74 °C.

## Patentansprüche

1. Fertigprodukt, welches ein Gas mit einer erhöhten Haltbarkeit aufweist, wobei das Produkt das Folgende aufweist:
a) einen Behälter, welcher einen Innenraum und eine saubere und passivierte Metallinnenfläche aufweist;
b) eine in dem Innenraum enthaltene Zusammensetzung, welche ein reaktives Gas aufweist und mit der sauberen passivierten Metallinnenfläche in Kontakt steht, wobei das reaktive Gas eine Konzentration aufweist, die weitgehend beibehalten wird; und
c) wobei die saubere und passivierte Metallinnenfläche das Folgende aufweist:
1) das Reaktionsprodukt eines siliciumhaltigen Materials und eines sauerstoffhaltigen Materials und
2) eine Menge des reaktiven Gases, wobei die Menge aus einer vorigen Begasung des Reaktionsproduktes mit einer hohen Konzentration des reaktiven Gases vor der Evakuierung des hochkonzentrierten reaktiven Gases aus dem Innenraum und vor dem Befüllen des Innenraums mit der Zusammensetzung resultiert, wobei die hohe Konzentration höher ist als die Konzentration des reaktiven Gases, die weitgehend beibehalten wird.

2. Produkt nach Anspruch 1, wobei das reaktive Gas aus der Gruppe ausgewählt ist, die aus Stickstoff(I)-oxid, Stickstoff(II)-oxid, Chlorwasserstoff, Chlor, Bortrichlorid und Säuregasen besteht, die mit einem siliciumhaltigen Material nicht reagieren.

3. Produkt nach Anspruch 2, wobei das Gas aus der Gruppe ausgewählt ist, die aus Schwefelkohlenstoff, Carbonylsulfid und Verbindungen der Formel (I) besteht:
Y-S-X (I)
wobei S für Schwefel steht und
X und Y gleich oder verschieden sind und unabhängig voneinander aus der Gruppe ausgewählt sind, die aus Wasserstoff, Alkyl, Aryl, Sauerstoff, Hydroxyl, Amino und Aminosilan besteht.

4. Produkt nach Anspruch 1, wobei es sich bei der passivierten Innenfläche um ein passiviertes Metall handelt.

5. Produkt nach Anspruch 4, wobei das Metall aus der Gruppe ausgewählt ist, die aus Aluminium, Aluminiumlegierungen, Stahl, Eisen und Kombinationen daraus besteht.

6. Produkt nach Anspruch 1, wobei das siliciumhaltige Material aus der Gruppe ausgewählt ist, die aus Verbindungen der folgenden allgemeinen Formel besteht:
SiR1R2R3R4,
wobei R1, R2, R3 und R4 unabhängig voneinander aus der Gruppe ausgewählt sind, die aus Wasserstoff, Halogen, Alkyl, Aryl, einem Amin, halogeniertem Alkyl und halogeniertem Aryl besteht.

7. Produkt nach Anspruch 6, wobei es sich bei der Verbindung um ein methyliertes Silan handelt.

8. Produkt nach Anspruch 7, wobei das methylierte Silan aus der Gruppe ausgewählt ist, die aus Methylsilan, Dimethylsilan, Trimethylsilan und Tetramethylsilan besteht.

9. Produkt nach Anspruch 1, wobei die Zusammensetzung eine Konzentration an reaktivem Gas von ungefähr 1000 ppb aufweist, welche nicht um mehr als +/- 10 Prozent abweicht.

10. Produkt nach Anspruch 1, wobei die Zusammensetzung eine Konzentration an reaktivem Gas von ungefähr 500 ppb aufweist, welche nicht um mehr als +/- 15 Prozent abweicht.

11. Produkt nach Anspruch 1, wobei die Zusammensetzung eine Konzentration an reaktivem Gas von ungefähr 100 ppb aufweist, welche nicht um mehr als +/- 20 Prozent abweicht.

12. Produkt nach Anspruch 1, wobei die Zusammensetzung ein einziges reaktives Gas aufweist, welches mit einem Gas vermischt ist, das aus der Gruppe ausgewählt ist, die aus einem Inertgas, einem Kohlenwasserstoffgas und Gemischen dieser besteht.

13. Verfahren zur Herstellung des Fertigproduktes nach Anspruch 1 aus einem sauberen Behälter, wobei das Verfahren die folgenden Schritte aufweist:
i) Aussetzen einer Metallinnenfläche eines Behälters einer ersten Fluidzusammensetzung, welche eine siliciumhaltige Verbindung aufweist, für eine ausreichende Zeit, um zu ermöglichen, dass zumindest ein Teil der siliciumhaltigen Verbindung mit einer vorliegenden sauerstoffhaltigen Verbindung reagiert, um zumindest auf einem Teil der Metallinnenfläche eine siliciumbehandelte Fläche zu bilden, wobei die siliciumhaltige Verbindung aus der Gruppe ausgewählt ist, die aus Verbindungen der folgenden allgemeinen Formel besteht:
SiR1R2R3R4,
wobei R1, R2, R3 und R4 gleich oder verschieden sind und unabhängig voneinander aus der Gruppe ausgewählt sind, die aus Wasserstoff, Halogen, Alkyl, Aryl, einem Amin, halogeniertem Alkyl und halogeniertem Aryl besteht;
ii) Evakuieren des Behälters für eine ausreichende Zeit, um im Wesentlichen die gesamte siliciumhaltige Verbindung zu entfernen, die nicht mit der sauerstoffhaltigen Verbindung reagiert hat, um die siliciumbehandelte Fläche zu bilden;
iii) Aussetzen der siliciumbehandelten Fläche einer zweiten Fluidzusammensetzung, wobei die zweite Fluidzusammensetzung ein reaktives Gas aufweist, welches eine Konzentration aufweist, die höher als eine beabsichtigte Konzentration des reaktiven Gases des Fertigprodukts ist;
iv) Evakuieren des Behälters für eine ausreichende Zeit, um im Wesentlichen die gesamte zweite Fluidzusammensetzung zu entfernen, WOdurch die passivierte Metallinnenfläche in dem Behälter gebildet wird; und
v) Befüllen des Behälters mit einer dritten Fluidzusammensetzung, welche die beabsichtigte Konzentration des reaktiven Gases für das Fertigprodukt aufweist.

14. Verfahren nach Anspruch 13, wobei die siliciumhaltige Verbindung aus der Gruppe ausgewählt ist, die aus Silan und einem methylierten Silan besteht.

15. Verfahren nach Anspruch 14, wobei das methylierte Silan aus der Gruppe ausgewählt ist, die aus Methylsilan, Dimethylsilan, Trimethylsilan und Tetramethylsilan besteht.

16. Verfahren nach Anspruch 13, wobei die zweite Fluidzusammensetzung eine Konzentration an reaktivem Gas aufweist, die mindestens das Zehnfache der beabsichtigten Konzentration des reaktiven Gases beträgt.

17. Verfahren nach Anspruch 13, wobei die Schritte i) und ii) vor Schritt iii) wiederholt werden.

18. Verfahren nach Anspruch 13, wobei die Konzentration des siliciumhaltigen Gases, das in Schritt iii) verwendet wird, von ungefähr 100 ppm bis 100 Prozent reicht.

19. Verfahren nach Anspruch 13, wobei die erste Fluidzusammensetzung während des Schrittes i) auf eine Temperatur von nicht mehr als 74 °C erwärmt wird.

20. Verfahren nach Anspruch 13, wobei die zweite Fluidzusammensetzung während des Schrittes iii) auf eine Temperatur von nicht mehr als 74 °C erwärmt wird.

## Revendications

1. Produit manufacturé comprenant un gaz ayant une durée de conservation prolongée, le produit comprenant :
a) un récipient comportant un espace interne et une surface métallique interne propre et passivée ;
b) une composition comprenant un gaz réactif contenue à l'intérieur de l'espace interne et en contact avec la surface métallique interne propre et passivée, le gaz réactif ayant une concentration qui est sensiblement maintenue ; et
c) la surface métallique interne propre et passivée comprenant :
1) le produit de réaction d'un matériau contenant du silicium et d'un matériau contenant de l'oxygène, et
2) une certaine quantité du gaz réactif, la quantité résultant d'une exposition préalable dudit produit de réaction à une forte concentration du gaz réactif avant l'évacuation du gaz réactif à forte concentration de l'espace interne et avant le remplissage de l'espace interne avec la composition, la forte concentration étant supérieure à la concentration de gaz réactif sensiblement maintenue.

2. Produit selon la revendication 1 dans lequel ledit gaz réactif est choisi dans le groupe constitué par l'oxyde nitreux, l'oxyde nitrique, le chlorure d'hydrogène, le chlore, le trichlorure de bore, et un gaz acide qui ne réagira pas avec un matériau contenant du silicium.

3. Produit selon la revendication 2 dans lequel ledit gaz acide est choisi dans le groupe constitué par le disulfure de carbone, le sulfure de carbonyle, et les composés de formule (I) :
Y-S-X (I)
dans laquelle S est le soufre, et
X et Y sont identiques ou différents et sont indépendamment choisis dans le groupe constitué par l'hydrogène, les groupes alkyle, les groupes aryle, l'oxygène, le groupe hydroxyle, le groupe amino, et les aminosilanes.

4. Produit selon la revendication 1 dans lequel ladite surface interne passivée est un métal passivé.

5. Produit selon la revendication 4 dans lequel ledit métal est choisi dans le groupe constitué par l'aluminium, les alliages d'aluminium, l'acier, le fer, et les combinaisons de ceux-ci.

6. Produit selon la revendication 1 dans lequel ledit matériau contenant du silicium est choisi dans le groupe constitué par les composés de formule générale :
SiR1R2R3R4
dans laquelle R1, R2, R3 et R4 sont indépendamment choisis dans le groupe constitué par l'hydrogène, les halogènes, les groupes alkyle, les groupes aryle, les amines, les groupes alkyle halogénés, et les groupes aryle halogénés.

7. Produit selon la revendication 6 dans lequel ledit composé est un silane contenant des groupes méthyle.

8. Produit selon la revendication 7 dans lequel ledit silane contenant des groupes méthyle est choisi dans le groupe constitué par le méthylsilane, le diméthylsilane, le triméthylsilane et le tétraméthylsilane.

9. Produit selon la revendication 1 dans lequel la composition a une concentration de gaz réactif d'environ 1000 ppb et qui ne varie pas de plus de ± 10 pour cent.

10. Produit selon la revendication 1 dans lequel la composition a une concentration de gaz réactif d'environ 500 ppb et qui ne varie pas de plus de ± 15 pour cent.

11. Produit selon la revendication 1 dans lequel la composition a une concentration de gaz réactif d'environ 100 ppb et qui ne varie pas de plus de ± 20 pour cent.

12. Produit selon la revendication 1 dans lequel la composition comprend un seul gaz réactif mélangé avec un gaz choisi dans le groupe constitué par un gaz inerte, un hydrocarbure gazeux, et les mélanges de ceux-ci.

13. Procédé de fabrication du produit manufacturé de la revendication 1 à partir d'un récipient propre, le procédé comprenant les étapes consistant à :
i) exposer une surface métallique interne d'un récipient à une première composition fluide comprenant un composé contenant du silicium pendant un temps suffisant pour permettre à au moins une partie du composé contenant du silicium de réagir avec un composé contenant de l'oxygène présent pour former une surface traitée au silicium sur au moins une partie de la surface métallique interne, le composé contenant du silicium étant choisi dans le groupe constitué par les composés de formule général :
SiR1R2R3R4
dans laquelle R1, R2, R3 et R4 sont identiques ou différents et sont indépendamment choisis dans le groupe constitué par l'hydrogène, les halogènes, les groupes alkyle, les groupes aryle, les amines, les groupes alkyle halogénés, et les groupes aryle halogénés ;
ii) évacuer le récipient pendant un temps suffisant pour éliminer sensiblement tout le composé contenant du silicium qui n'a pas réagi avec le composé contenant de l'oxygène pour former la surface traitée au silicium ;
iii) exposer la surface traitée au silicium à une deuxième composition fluide, la deuxième composition fluide comprenant un gaz réactif ayant une concentration qui est supérieure à une concentration de gaz réactif souhaitée du produit manufacturé ;
iv) évacuer le récipient pendant un temps suffisant pour éliminer sensiblement toute la deuxième composition fluide, formant ainsi ladite surface métallique interne passivée dans le récipient ; et
v) remplir le récipient avec une troisième composition fluide ayant la concentration de gaz réactif souhaitée pour le produit manufacturé.

14. Procédé selon la revendication 13 dans lequel le composé contenant du silicium est choisi dans le groupe constitué par le silane et un silane contenant des groupes méthyle.

15. Procédé selon la revendication 14 dans lequel ledit silane contenant des groupes méthyle est choisi dans le groupe constitué par le méthylsilane, le diméthylsilane, le triméthylsilane et le tétraméthylsilane.

16. Procédé selon la revendication 13 dans lequel la deuxième composition fluide a une concentration de gaz réactif égale à au moins 10 fois la concentration de gaz réactif souhaitée.

17. Procédé selon la revendication 13 dans lequel les étapes i) et ii) sont répétées avant l'étape iii).

18. Procédé selon la revendication 13 dans lequel la concentration du gaz contenant du silicium utilisé à l'étape iii) va d'environ 100 ppm à 100 pour cent.

19. Procédé selon la revendication 13 dans lequel, lors de l'étape i), la première composition fluide est chauffée à une température ne dépassant pas 74 °C.

20. Procédé selon la revendication 13 dans lequel, lors de l'étape iii), la deuxième composition fluide est chauffée à une température ne dépassant pas 74 °C.
